(19) **Europäisches Patentamt / European Patent Office / Office européen des brevets**

(11) **EP 2 164 176 A1**

(12) **EUROPEAN PATENT APPLICATION**

(43) Date of publication:
**17.03.2010 Bulletin 2010/11**

(51) Int Cl.:
***H03M 7/40*** *(2006.01)*

(21) Application number: **08305547.5**

(22) Date of filing: **12.09.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **Thomson Licensing**
**92443 Issy-les-Moulineaux Cedex (FR)**

(72) Inventors:
• **AN, Jicheng**
**100085, Beijing (CN)**

• **CHEN, Quqing**
**100085, Beijing (CN)**
• **CHEN, Zhibo**
**100085, Beijing (CN)**
• **TENG, Jun**
**100085, Beijing (CN)**

(74) Representative: **Hartnack, Wolfgang**
**Deutsche Thomson OHG**
**European Patent Operations**
**Karl-Wiechert-Allee 74**
**30625 Hannover (DE)**

(54) **Method for lossless compressing prefix-suffix-codes, method for decompressing a bit sequence representing integers or symbols encoded in compressed prefix-suffix-codes and storage medium or signal carrying compressed prefix-suffix-codes**

(57) The invention is related to lossless compression of prefix-suffix-codes wherein a prefix comprises unary code, and to corresponding decompression.

The method for lossless compressing prefix-suffix-codes (VLC1, VLC2, VLC3) comprises the steps of forming a first contiguous bit sequence (FBS) from the prefixes (PRFX1, PRFX2, PRFX3), and lossless compressing the first contiguous bit sequence (FBS) by removing redundancy related to the difference between the first value's frequency in the first contiguous bit sequence (FBS) and the second value's frequency in the first contiguous bit sequence (FBS).

Bit values are unevenly distributed in the prefixes while distribution of bit values in the suffixes is more even. Therefore, better compression is achievable if the prefixes are compressed separately.

Fig. 1

**Description**

Background

The invention is related to a method for lossless compressing prefix-suffix-codes, wherein each prefix comprises a sequence of bits of a first value terminated by a stop bit of a different second value, and to a method for decompressing a bit sequence representing integers or symbols encoded in compressed prefix-suffix-codes. The invention is further related to a storage medium or a signal carrying compressed prefix-suffix-codes.

Prefix-suffix-codes are used in variable length coding (VLC), for instance. In most VLC schemes, integers or symbols are represented by a two-part bit sequence of variable length wherein a preceding part of the bit sequence carries the prefix indicating the number of bits in a succeeding part which carries a representation of encoded pay load data as the suffix. The prefix indicates said number of bits by unary code, i.e. by a same number of equally valued bits terminated by a stop bit of different value.

VLC is used in coding of information related to audio, image, video, multimedia, computer games, 3D mesh data, text, file, and so on. For instance, syntax elements of macro-blocks of images or video frames are encoded with VLC.

Although VLC provides very compact representations of integers or symbols, even more compact representations are desirable.

Invention

A lossless compression of prefix-suffix-codes, wherein each prefix comprises a sequence of bits of a first value terminated by a stop bit of a different second value, is achieved by a method comprising the features of claim 1.

Said method comprises the steps of forming a first contiguous bit sequence from the prefixes, forming a second contiguous bit sequence from the suffixes, lossless compressing the first contiguous bit sequence by removing redundancy related to the difference between the first value's frequency in the first contiguous bit sequence and the second value's frequency in the first contiguous bit sequence.

Bit values are unevenly distributed in the prefixes while distribution of bit values in the suffixes is more even. Therefore, better compression is achievable if the prefixes are compressed separately.

In an embodiment, the method further comprises the steps of forming a second contiguous bit sequence from the suffixes and appending said second contiguous bit sequence to the compressed first bit sequence.

In a further embodiment, the step of lossless compressing comprises arithmetic coding of the first contiguous bit sequence.

The arithmetic code of the first contiguous bit sequence may comprise information related to the first value's frequency and/or the second value's frequency in the first contiguous bit sequence.

In another embodiment, the step of lossless compressing comprises compression based on an adaptive dictionary.

The adaptive dictionary-based compression may be Lempel-Ziv compression or Lempel-Ziv-Welch compression.

In a further embodiment, the compressed first bit sequence comprises one or more flag bits indicating that and/or by which compression method the first contiguous bit sequence is compressed.

A decompression of a bit sequence representing integers or symbols encoded in compressed prefix-suffix-codes may be achieved by a method comprising the features of claim 7.

Said decompressing method comprises the steps of decompressing a first contiguous subsequence comprised in the bit sequence and separating the decompressed first contiguous subsequence at stop bits into the prefixes.

In an embodiment, the decompressing method further comprises using the prefixes for separating a second contiguous subsequence comprised in the remainder of the bit sequence into the suffixes.

In a further embodiment, the decompressing method further comprises extracting information related to a relative frequency of a bit value in the first subsequence wherein the first subsequence is decompressed by arithmetic decoding using the extracted information.

In another embodiment of the decompressing method, the first contiguous subsequence is decompressed by an adaptive dictionary-based decompression method, for instance, by a Lempel-Ziv decompression method or by a Lempel-Ziv-Welch decompression method.

In yet a further embodiment, the decompressing method further comprises evaluating one or more flag bits indicating that and/or by which decompression method the first subsequence has to be decompressed and decompressing the first contiguous subsequence, accordingly.

The invention further proposes a storage medium or signal carrying a bit sequence representing integers or symbols encoded in compressed prefix-suffix-codes, said integers or symbols representing information related to audio and/or video, wherein said bit sequence comprises a first contiguous subsequence representing compressed prefixes and a disjoint second contiguous subsequence representing suffixes.

In an embodiment of the storage medium or the signal, said compressed prefix-suffix-codes being compressed according to the inventive method for lossless compressing prefix-suffix-codes or one of the embodiments of said method.

The bit sequence carried by the storage medium or the signal may comprise information related to the first value's frequency and/or the second value's frequency in the first contiguous bit sequence.

And/Or, the bit sequence carried by the storage medium or the signal may comprise one or more flag bits indicating that and/or by which compression method the first contiguous subsequence is compressed.

The storage medium may be a disk-like optical medium, for instance a DVD, a HD-DVD or a Bluray Disk, or a magnetic medium, for instance a hard disk or a tape drive, or any other kind of storage medium.

The inventive effects establish well, if the prefix-suffix-codes are variable length codes of integers representing information related to audio and/or video data. For instance, the integers may represent syntax elements of a same type, said syntax elements being associated with macro blocks of an image or a video frame.

Exemplary embodiments of the invention are explained in more detail in the following description.

Drawings

Exemplary embodiments of the invention are illustrated in the drawings and are explained in more detail in the following description.

In the figures:

Fig. 1    depicts a first exemplary embodiment of lossless compression of prefix-suffix-codes and

Fig. 2    depicts a second exemplary embodiment of lossless compression of prefix-suffix-codes.

Exemplary embodiments

VLC codes use varying integer number of bits for representation of different symbols. Huffman coding is the most widely used VLC method. It assigns fewer bits to the symbol with greater probability, while assigning more bits to the symbol with smaller probability. Huffman coding proves to be the best VLC method for source coding, but it needs a complex process to construct the Huffman tree. Moreover, Huffman code is more suitable for a finite number of symbols or values. But, in many cases there are an infinite number of symbols, e.g., the symbols are integer numbers.

Therefore, in practice, some simpler VLC codes are proposed, for example, the Golomb-code, which has some particular derivatives such as Golomb-Rice code, Exponential Golomb (Exp-Golomb) code, and Hybrid Golomb code. Unary code is a specific Golomb-Rice code. Table 1 shows examples of different kinds of Golomb codes:

Table 1: Derivatives of Golomb-code

| $n$ | Unary Code | Golomb-Rice Code | Exp-Golomb Code | Hybrid Golomb Code |
|---|---|---|---|---|
| 0 | 1 | 10 | 1 | 1 |
| 1 | 01 | 11 | 010 | 01 |
| 2 | 001 | 010 | 011 | 0010 |
| 3 | 0001 | 011 | 00100 | 00110 |
| 4 | 00001 | 0010 | 00101 | 00111 |
| 5 | 000001 | 0011 | 00110 | 000100 |
| 6 | 0000001 | 00010 | 00111 | 000101 |
| 7 | 00000001 | 00011 | 0001000 | 000110 |
| 8 | 000000001 | 000010 | 0001001 | 0001110 |
| 9 | 0000000001 | 000011 | 0001010 | 0001111 |
| 10 | 00000000001 | 0000010 | 0001011 | 00001000 |
| ... | ... | ... | ... | ... |

These above mentioned variable length codes are simple and suitable for coding signal sources with a certain statistic probability distribution. For example, the unary code is optimal if symbol $n$ appears with probability $P_U(n)=2^{-(n+1)}$. Similarly, the there are probability distributions $P_{RC}(n)$, $P_{ExG}(n)$ and $P_{HG}(n)$ for which Golomb-Rice code, Exp-Golomb Code or Hybrid Golomb code is optimal. However, in practice signal sources are not completely in accordance with any of said probability distribution. Thus there remains a redundancy within the VLC codes, which has not been taken into account in the VLC coding tools in previous audio or image/video coding schemes.

VLC code like Exp-Golomb code and Huffman code (but not unary code) is also referred to as prefix code or prefix-suffix-code. A prefix code has a prefix property: no code word VLC1, VLC2, VLC3 is a prefix PRFX1, PRFX2, PRFX3 of any other code word VLC1, VLC2, VLC3 in the set. Typically, the Golomb Code and Huffman Code can be represented in the following format:

00...01XXXXX prefix: 00...01 suffix: XXXXX ("X" can be "1" or "0")

That is: several consecutive "0" and a "1" form the prefix PRFX1, PRFX2, PRFX3 and the subsequent XXXXX forms the suffix SFFX1, SFFX2, SFFX3. Generally, the probabilities of "0" and "1" in the suffixes SFFX1, SFFX2, SFFX3 are about the same, i.e., 50%. Thus, there is little room to further compress suffixes SFFX1, SFFX2, SFFX3.

However, the probability of "0" and "1" in the prefixes PRFX1, PRFX2, PRFX3, are not the same in many scenarios, or even quite different. It means, the Huffman code is not optimal and can not achieve the optimal bit rate.

For example, in H.264/AVC standard, when Context based Adaptive Binary Arithmetic Coding (CABAC) is not used, Exp-Golomb code is employed to encode all the header information while Context based Adaptive Variable Length Coding (CAVLC) is employed to encode transform coefficients information. The header information includes kinds of syntax elements having different probability distributions. These probability distributions may not be exactly the expected one of the Exp-Golomb code. Therefore, the Exp-Golomb code cannot approach the Shannon entropy. Table 2 shows the number and probability of "0" and "1" in the prefixes of VLC codes VLC1, VLC2, VLC3 for three different syntax elements:

Table 2: The probability distribution of 0 and 1 in the prefixes of VLC codes of different syntax elements

| Syntax element | The number of 0 / probability | The number of 1 / probability |
| --- | --- | --- |
| **mb_qp_delta** | 15101 / 0.31 | 33231 / 0.69 |
| **mb_skip_run** | 27023 / 0.28 | 68221 / 0.72 |
| **ref_idx** | 63569 / 0.72 | 25209 / 0.28 |

The CIF sequence Foreman (300 frames, 30 f/s) was used to obtain the statistic data. The profile was baseline, rate control was enabled and the target bit rate was set to 300020 bps. The encoder parameter "numberReferenceFrames" was set to 2. Therefore, the syntax element ref_idx had only two optional values: 0 and 1 (This is an exceptional case of the Exp-Globe code, i.e., the truncated Exp-Golomb code in H.264/AVC standard.). It can be seen from Table 2 that the probabilities of 0 and 1 are obviously different for each syntax element. It is to say that there is redundancy within the prefixes. This phenomenon is generated due to the following reasons:

Quantization parameter QPs in the neighboring macro-blocks are mostly identical, i.e., the probability of "mb_qp_delta=0" is more than a half, so there are much more "1" appeared in the prefixes according to Exp-Golomb code.

Most macro-blocks are not skipped, i.e., the probability of "mb_skip_run=0" is more than a half, so there are more "1" appeared in the prefixes according to Exp-Golomb code.

The reference frame is mostly the immediately previous frame, i.e., the probability of "ref_idx=0" is more than a half, so there are more "0" appeared in the prefixes according to the truncated Exp-Golomb code.

The uneven distribution of "0" and "1" in the prefixes can be exploited for further compression.

Therefore, it is proposed to remove the redundancy due to the uneven distribution of binary symbols in the prefixes of, for example, variable length codes of some certain syntax elements.

This results in an improvement of compression performance of the variable length coding.

The invention proposes to group the prefixes PRFX1, PRFX2, PRFX3 of a number of VLC codes VLC1, VLC2, VLC3 together after traditional variable length coding, and use arithmetic coding, a Lempel-Ziv based coding method, a Lempel-Ziv-Welsh based coding method or any other lossless compression method to further remove the redundancy within the prefixes PRFX1, PRFX2, PRFX3 of a lot of VLC codes VLC1, VLC2, VLC3 due to the uneven distribution of binary symbols.

Arithmetic coding encodes the probability of "0" or "1" in the bit-stream to indicate a probability distribution to a decoder.

Lempel-Ziv (LZ) based compression methods, like Lempel-Ziv-Welsh (LZW) based compression methods or Lempel-Ziv-Renau (LZR) compression methods, are adaptive dictionary compression methods which are based on a dictionary of repeated strings. For most LZ methods, said dictionary being adaptively built during encoding and needs not to be send to the decoder as the dictionary can be built during decoding the same way as during encoding. Other compression methods require insertion of a dictionary into the bit stream.

LZ compression methods commonly utilize a table for substituting reappearing strings of data by a reference to an entry in the table. For most LZ methods, this table is generated dynamically from earlier data in the input. The table itself is often Huffman encoded. Examples of LZ compression are present in GIF images which comprise data compressed according to Lempel-Ziv-Welch (LZW) and in zip-compression which makes use of a Lempel-Ziv-Renau (LZR) compression method.

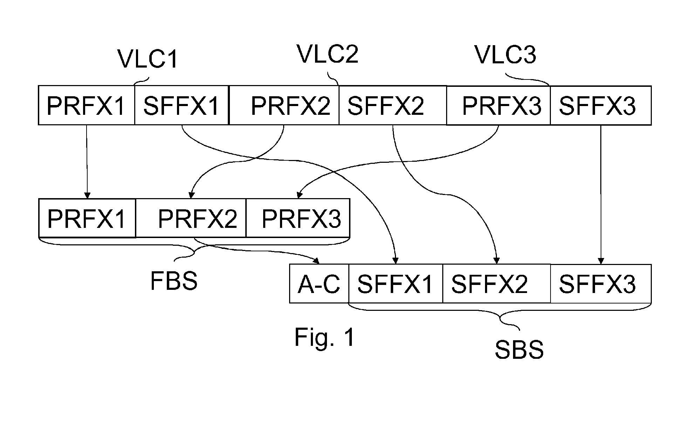

In a first exemplary embodiment depicted in fig. 1, arithmetic coding of binary alphabet is used to further improve the compression performance of the VLC codes VLC1, VLC2, VLC3. The steps of said exemplary embodiment may comprise:

(1) Using traditional VLC for encoding of a variety of syntax elements, e.g., the H.264/AVC.

(2) Grouping prefixes PRFX1, PRFX2, PRFX3, of a number of certain VLC codes VLC1, VLC2, VLC3 together, e.g., all the prefixes PRFX1, PRFX2, PRFX3 of mb_qp_delta in one slice are grouped together, and all the prefixes PRFX1, PRFX2, PRFX3, of mb_skip_run in one slice are grouped together. Other syntax elements such ref_idx or coefficients related syntax elements can be treated similarly as well.

(3) Arithmetic coding of the prefixes PRFX1, PRFX2, PRFX3 within each group FBS for removal of the redundancy due to uneven distribution of "0" and "1". This results in a compressed code A-C. The primary advantage of the arithmetic coding compared with Huffman coding is that there is no further blocking (or grouping) needed even for the binary alphabet. Normally, the arithmetic coding of the binary strings can almost reach its Shannon entropy rate.

(4) If no adaptive binary algorithm coding is used, adding of information related to the probability of "0" or "1" to the compressed bit-stream A-C is advantageous. The arithmetic decoder needs to use the symbol probabilities of "0" and "1" which are identical to that used in encoder for accurate decoding. If default symbol probabilities are used, the achieved bit rate will deviate from an optimal one and therefore will remain sub-optimal. Thus, it is advantageous to use the actually symbol probabilities of each syntax element for encoding and to sent the used symbol probabilities together with the compressed data to the decoder. For the probability precision 0.01 used in the above example, 7 bits (1/128) is enough to represent. This overhead is quite negligible relative to the bits reduction by arithmetic coding. If adaptive binary algorithm coding is used, the probability is adaptively calculated during the coding process and during the de-coding process, and no side information about symbol probability needs to be sent from encoder to decoder.

Exemplarily, bit reductions for the syntax elements of table 2 due to further arithmetic coding of prefixes PRFX1, PRFX2, PRFX3 of traditional VLC codes VLC1, VLC2, VLC3 are about:

$$\left[1-\left(0.31\times\log_2\left(\frac{1}{0.31}\right)+0.69\times\log_2\left(\frac{1}{0.69}\right)\right)\right]\times\left(15101+33231\right)\approx 5163 \quad \text{bits for mb\_qp\_delta}$$

which corresponds to bit rate reduction of about 10.7%,

$$\left[1-\left(0.28\times\log_2\left(\frac{1}{0.28}\right)+0.72\times\log_2\left(\frac{1}{0.72}\right)\right)\right]\times\left(27023+68221\right)\approx 13767 \quad \text{bits for mb\_skip\_}$$

run which corresponds to bit rate reduction of about 14.5% and

$$\left[1-\left(0.28\times\log_2\left(\frac{1}{0.28}\right)+0.72\times\log_2\left(\frac{1}{0.72}\right)\right)\right]\times\left(25209+63569\right)\approx 12833 \quad \text{bits for ref\_idx}$$

which also corresponds to bit rate reduction of about 14.5%.

(5) Optionally, inserting one or more flag bits may be comprised in said exemplary embodiment wherein said flag bits indicate that and/or by which compression method the prefixes are compressed, further.

A bit sequence SBS formed from the suffixes SFFX1, SFFX2, SFFX3 may be appended to the compressed code A-C.

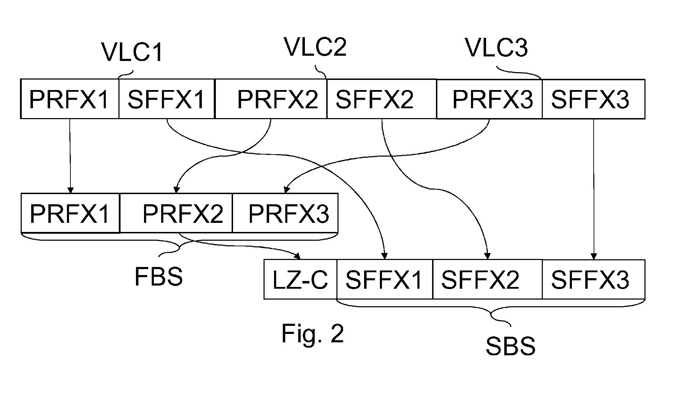

In a second exemplary embodiment depicted in fig. 2, LZ, LZR or LZW compression is used for further compressing prefixes. The steps of said another exemplary embodiment may comprise:

(1) Using traditional VLC for encoding of a variety of syntax elements, e.g., the H.264/AVC.

(2) Grouping prefixes PRFX1, PRFX2, PRFX3, of a number of certain VLC codes VLC1, VLC2, VLC3 together, e.g., all the prefixes PRFX1, PRFX2, PRFX3, of mb_qp_delta in one slice are grouped together, and all the prefixes PRFX1, PRFX2, PRFX3 of mb_skip_run in one slice are grouped together. Other syntax elements such ref_idx or coefficients related syntax elements can be treated similarly as well.

(3) Using a Lempel-Ziv based method (e.g. zip-compression) or a Lempel-Ziv-Welsh based method for further compressing the grouped prefixes FBS. This results in another compressed code LZ-C.

(4) Optionally, inserting one or more flag bits may be comprised in said another exemplary embodiment wherein said flag bits indicate that and/or by which compression method the prefixes are further compressed.

A bit sequence SBS formed from the suffixes SFFX1, SFFX2, SFFX3 may be appended to the another compressed code LZ-C.
A variable length coding method is proposed, which groups the prefixes or a number of VLC coded code words together, and then use a second entropy coding method for removal of the redundancy due to the uneven distribution of binary symbols.
The variable length coding method proposed may use one or more bits in the bit-stream to indicate whether the new prefix compressed entropy coding method is used or the traditional entropy coding is used.
The idea of using arithmetic coding or Lempel-Zip based coding for compressing the prefixes of a number of variable length coded code words can be used in any data compression cases, including audio, image, video, 3D mesh data, text, file, and so on.

**Claims**

1. Method for lossless compressing prefix-suffix-codes (VLC1, VLC2, VLC3) each prefix (PRFX1, PRFX2, PRFX3) comprising a sequence of bits of a first value terminated by a stop bit of a different second value, said method comprises the steps of

   - forming a first contiguous bit sequence (FBS) from the prefixes (PRFX1, PRFX2, PRFX3),
   - lossless compressing the first contiguous bit sequence (FBS) by removing redundancy related to the difference between the first value's frequency in the first contiguous bit sequence and the second value's frequency in the first contiguous bit sequence (FBS).

2. Method according to claim 1, further comprising the steps of

   - forming a second contiguous bit sequence from the suffixes and
   - appending said second contiguous bit sequence to the compressed first bit sequence.

3. Method according to claim 1 or 2, wherein

   - the step of lossless compressing comprises arithmetic coding of the contiguous bit sequence.

4. Method according to claim 3, wherein the arithmetic code of the first contiguous bit sequence (FBS) comprises information related to the first value's frequency and/or the second value's frequency in first contiguous bit sequence (FBS).

5. Method according to claim 1 or 2, wherein

   - the step of lossless compressing comprises compression based on an adaptive dictionary like Lempel-Ziv compression or Lempel-Ziv-Welch compression.

6. Method according to one of the preceding claims, wherein the compressed first bit sequence (A-C, LZ-C) comprises one or more flag bits indicating that and/or by which compression method the first contiguous bit sequence (FBS) is compressed.

7. Method for decompressing a bit sequence representing integers or symbols encoded in compressed prefix-suffix-codes, said method comprises the steps of

   - decompressing a first contiguous subsequence (A-C, LZ-C) comprised in the bit sequence and
   - separating the decompressed first contiguous subsequence (FBS) at stop bits into the prefixes (PRFX1, PRFX2, PRFX3).

8. Method according to claim 7, further comprising

   - using the prefixes (PRFX1, PRFX2, PRFX3) for separating a second contiguous subsequence (SBS) comprised in the remainder of the bit sequence into the suffixes (SFFX1, SFFX2, SFFX3).

9. Method according to claim 7 or 8, further comprising

   - extracting information related to a relative frequency of a bit value in the first subsequence (FBS) wherein
   - the first subsequence (FBS) is decompressed by arithmetic decoding using the extracted information.

10. Method according to claim 7 or 8, wherein

    - the first contiguous subsequence (FBS) is decompressed by an adaptive dictionary-based decompression method for instance by a Lempel-Ziv decompression method or by a Lempel-Ziv-Welch decompression method.

11. Method according to one of the claims 7 to 10, said method further comprising

    - evaluating one or more flag bits indicating that and/or by which decompression method the first contiguous subsequence (FBS) has to be decompressed and
    - decompressing the first contiguous subsequence (FBS), accordingly.

12. Storage medium or signal carrying a bit sequence representing integers or symbols encoded in compressed prefix-suffix-codes, said integers or symbols representing information related to audio and/or video, wherein said bit sequence comprises a first contiguous subsequence representing compressed prefixes and a disjoint second contiguous subsequence representing suffixes.

13. Storage medium or signal according to claim 12, wherein said compressed prefix-suffix-codes are compressed according to one of the claims 1 to 6.

14. Method according to one of the claims 1 to 11 or storage medium or signal according to claim 12 or 13, wherein the prefix-suffix-codes are variable length codes (VLC1, VLC2, VLC3) of integers representing information related to audio and/or video data.

15. Method, storage medium or signal according to claim 14, wherein the integers represent syntax elements of a same type, said syntax elements being associated with macro blocks of an image or a video frame.

VLC1      VLC2      VLC3

| PRFX1 | SFFX1 | PRFX2 | SFFX2 | PRFX3 | SFFX3 |

| PRFX1 | PRFX2 | PRFX3 |

FBS

| A-C | SFFX1 | SFFX2 | SFFX3 |

Fig. 1

SBS

VLC1          VLC2          VLC3

| PRFX1 | SFFX1 | PRFX2 | SFFX2 | PRFX3 | SFFX3 |

| PRFX1 | PRFX2 | PRFX3 |

FBS

| LZ-C | SFFX1 | SFFX2 | SFFX3 |

Fig. 2

SBS

Europäisches
Patentamt

European
Patent Office

Office européen
des brevets

# EUROPEAN SEARCH REPORT

Application Number

EP 08 30 5547

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2004/008769 A1 (WINGER LOWELL [CA]) 15 January 2004 (2004-01-15) * abstract * * paragraphs [0010], [0011], [0027], [0036], [0039] * | 1-15 | INV. H03M7/40 |
| X | US 2004/085233 A1 (LINZER ELLIOT N [US] ET AL) 6 May 2004 (2004-05-06) * paragraphs [0031] - [0033]; figure 5 * | 1-15 | |
| X | "Huffman Coding" [Online] 28 February 2008 (2008-02-28), , XP002509842 Retrieved from the Internet: URL:http://en.wikipedia.org/wiki/Huffman_coding> [retrieved on 2009-01-11] * page 1 * | 1 | |
| Y | WO 94/27374 A (APPLE COMPUTER [US]) 24 November 1994 (1994-11-24) * abstract * | 1-15 | TECHNICAL FIELDS SEARCHED (IPC) |
| Y | EP 1 545 133 A (LSI LOGIC CORP [US]) 22 June 2005 (2005-06-22) * abstract * | 1-15 | H03M |
| A | T.WIEGAND,G.J.SULLIVAN,G. BJONTEGAARD, A.LUTHRA: "Overview of the H.264/AVC Video Coding Standard" IEEE TRANSACTIONS ON CIRCUITS AND SYSTEMS FOR VIDEO TECHNOLOGY, vol. 13, no. 7, July 2003 (2003-07), pages 560-576, XP002509016 * the whole document * | 1-15 | |

-/--

The present search report has been drawn up for all claims

| Place of search | Date of completion of the search | Examiner |
|---|---|---|
| The Hague | 12 January 2009 | Belardinelli, Carlo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EUROPEAN SEARCH REPORT**

Application Number

EP 08 30 5547

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | D.MARPE, H. SCHWARZ, T.WIEGAND: "Contetxt-Based Adaptive Binary Arithmetic Coding in the H.264/AVC Video Compression Standard" IEEE TRANSACTIONS ON CIRCUITS AND SYSTEMS FOR VIDEO TECHNOLOGY, vol. 13, no. 7, July 2003 (2003-07), pages 620-636, XP002509017 * the whole document * ----- | 1-15 | |
| A | US 5 774 081 A (CHENG JOE-MING [US] ET AL) 30 June 1998 (1998-06-30) * abstract * ----- | 1-15 | |

TECHNICAL FIELDS
SEARCHED    (IPC)

The present search report has been drawn up for all claims

| Place of search | Date of completion of the search | Examiner |
|---|---|---|
| The Hague | 12 January 2009 | Belardinelli, Carlo |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

....................................................................................

& : member of the same patent family, corresponding
document

EPO FORM 1503 03.82 (P04C01)

**ANNEX TO THE EUROPEAN SEARCH REPORT
ON EUROPEAN PATENT APPLICATION NO.**

EP 08 30 5547

This annex lists the patent family members relating to the patent documents cited in the above-mentioned European search report.
The members are as contained in the European Patent Office EDP file on
The European Patent Office is in no way liable for these particulars which are merely given for the purpose of information.

12-01-2009

| Patent document cited in search report | | Publication date | Patent family member(s) | | Publication date |
|---|---|---|---|---|---|
| US 2004008769 | A1 | 15-01-2004 | US | 2004150540 A1 | 05-08-2004 |
| US 2004085233 | A1 | 06-05-2004 | NONE | | |
| WO 9427374 | A | 24-11-1994 | AU | 6911894 A | 12-12-1994 |
| EP 1545133 | A | 22-06-2005 | NONE | | |
| US 5774081 | A | 30-06-1998 | NONE | | |

EPO FORM P0459

For more details about this annex : see Official Journal of the European Patent Office, No. 12/82